# EUROPEAN PATENT SPECIFICATION

(11) **EP 0 204 563 B1**
(45) Date of publication and mention of the grant of the patent: **20.01.1993**
(21) Application number: 86304269.3
(22) Date of filing: 04.06.1986
(51) Int. Cl.: C23C 16/40, H01L 31/02

(54) **Process for depositing zinc oxide**
Verfahren zum Niederschlagen einer Schicht aus Zinkoxid
Procédé pour le dépôt d'une couche d'oxyde de zinc

(30) Priority: 04.06.1985 US 741081
(43) Date of publication of application: 10.12.1986
(73) Proprietor: SIEMENS SOLAR INDUSTRIES L.P., Camarillo, California 93010 (US)
(72) Inventor: Vijayakumar, Patham, S., Granada Hills California 91344 (US); Blaker, Kimberly A., Granada Hills California 91344 (US); Wieting, Robert D., Simi Valley California 93065 (US); Wong, Boon, Reseda California (US)
(74) Representative: Fuchs, Franz-Josef, Dr.-Ing.

(56) References cited:
- THIN SOLID FILMS, vol. 96, no. 2, October 1982, pages 149-154, Elsevier Sequoia, Lausane, CH; M. SHIMIZU et al.: "Preparation of ZnO thin films by plasma-enhanced organometallic chemical vapour deposition"
- JOURNAL OF THE ELECTROCHEMICAL SOCIETY, vol. 128, no. 12, December 1981, pages 2684-2686, Manchester, New Hampshire, US; A.P. ROTH et al.: "Semiconducting zinc oxide films prepared by metal organic chemical vapor deposition from diethyl zinc"
- 1981 ULTRASONICS SYMPOSIUM PROCEEDINGS, Chicago, 14th - 16th October 1981, vol. 1, pages 498-501, IEEE; T. SHIOSAKI et al.: "Plasma-enhanced metalorganic chemical vapor deposition of C-axis oriented and epitaxial films of ZnO at low substrate temperatures"
- PATENT ABSTRACTS OF JAPAN, vol. 6, no. 219 (C-132)[1097], 2nd November 1982; & JP-A-57 123 968
- THIN SOLID FILMS, vol. 102, no. 1, April 1983, pages 1-46, Elsevier Sequoia, Lausanne, CH; K.L. CHOPRA et al.: "Transparent conductors-a status review"
- THIN SOLID FILMS, vol. 111, no. 2, January 1984, pages 167-174, Elsevier Sequoia, Lausanne, CH; T. MINAMI et al.: "The stability of zinc oxide transparent electrodes fabricated by R.F. Magnetron Sputtering"
- Hollemann-Wiberg, Lehrbuch der Anorganischen Chemie, 1976, page 827, Walter de Gruyter, Berlin-New York;
- Beyer, Lehrbuch der organischen Chemie, 1978, page 170, S. Hirzel Verlag, Stuttgart;
- Thin Film Processes, J.L. Vossen and W. Kern, Academic Press Inc., 1978, pages V-IX;

## Description

The present invention relates to the deposition of a zinc oxide film, for example such a film useful in photoconductive applications.

In many applications where a zinc oxide film is deposited upon a heat-sensitive substrate, such as a photoconductive layer or layers, it is not desirable to deposit the zinc oxide at temperatures which may adversely affect the substrate. Although zinc oxide films have been produced by chemical vapour deposition, such films have generally been produced only at high temperatures, for example at temperatures of 350° to 730°C. In addition, films so produced have been characterised by relatively high resistivities.

It is an object of the present invention to provide a process for depositing a zinc oxide film at a relatively low temperature.

The paper "Preparation of ZnO Thin Films by Plasma-Enhanced Organometallic Chemical Vapour Deposition" (Thin Solid Films, Vol. 96 (1982), pages 149-154) discloses a process for depositing a zinc oxide film on a substrate, the process comprising introducing an organozinc compound vapour, an oxidant and an inert carrier gas into a chamber containing a substrate. The oxidant is carbon dioxide and the process is carried out at 150-350°C in the presence of plasma enhancement.

The paper "Plasma-Enhanced Metalorganic Chemical Vapour Deposition of C-Axis Oriented and Epitaxial Films of ZnO at Low Substrate Temperatures" (1981 Ultrasonics Symposium, pages 498-501) discloses a process for depositing a zinc oxide film on a substrate, the process comprising introducing an organozinc compound vapour, an oxidant and an inert carrier gas into a chamber containing the substrate. The oxidant is oxygen or carbon dioxide and the process is carried out at around 80-300°C in the presence of plasma enhancement.

The paper "Transparent Conductors - A Status Review" (Thin Solid Films, Vol. 102 (1983), pages 1-46) refers generally, at pages 20 and 21, to various processes for depositing zinc oxide films, including chemical vapour deposition.

The paper "Semiconducting Zinc Oxide Films Prepared by Metal Organic Chemical Vapour Deposition from Diethyl Zinc" (Journal of the Electrochemical Society, Vol. 128, No. 12, December 1981, pages 2684-2686) discloses a process for depositing a zinc oxide film on a substrate in the absence of plasma enhancement, the process comprising introducing an organozinc compound vapour, an oxidant and an inert carrier gas into a chamber containing a substrate to deposit a zinc oxide film on the substrate. The oxidant is oxygen and the process is carried out at 280-480°C.

According to the present invention, there is provided a process for depositing a zinc oxide film on a substrate, the process comprising introducing an organozinc compound vapour, an oxidant and an inert carrier gas into a chamber containing a substrate to deposit a zinc oxide film on the substrate, the oxidant being water vapour and the substrate being heated to a temperature of up to about 200°C.

The film could be formed by introducing into the chamber an organozinc compound vapour in an amount of up to about 0.5 mole fraction in a stream of the inert carrier gas.

The water vapour introduced into the chamber could be in an amount of about one to about three moles per mole of organozinc compound.

Said temperature could be from about 100°C to about 200°C, for example up to about 150°C.

The film could contain an element of Group III of the periodic system, a volatile compound of said element being also introduced into the chamber.

The element could be boron, the volatile compound being diborane.

The volatile compound introduced into the chamber could be in an amount of about one to about four mole percent of the organozinc compound.

The organozinc compound could have the formula R₂Zn, with R being an alkyl radical, such as dimethylzinc or diethylzinc.

The film could have a thickness of up to about 2 micrometres.

Preferably, the resistivity of the film is within the range from about 10⁻⁴ to 10⁻² ohm-cm, for example less than about 2.5 x 10⁻³ ohm-cm.

The present invention enables zinc oxide films to be produced having properties which make them useful in photoconductive applications such as in solar cells and other photovoltaic devices.

The present invention enables an improved chemical vapour deposition process for depositing zinc oxide films upon substrates such as photoconductors. Since many photoconductors are heat sensitive, it is an advantage of this invention that the deposition of zinc oxide does not require high temperatures. The resistivity of the resulting zinc oxide film can be varied by the use of suitable additives. In fact, the resistivity can be varied during the deposition process to produce a film in which the resistivity varies from bottom to top. Another advantage is the low cost of depositing zinc oxide films using a process according to this invention.

Since the substrate is heated, deposition of zinc oxide upon the walls of the chamber may be substantially avoided. In addition, deposition takes place substantially only upon those areas of the substrate which are heated, thus making it possible to deposit a zinc oxide film upon the entire surface of the substrate or only selected portions thereof.

A system for depositing a zinc oxide film in accordance with one embodiment of the present invention utilises a chamber containing a heated table, means for introducing the reactants (which may include any desired volatile additive) into the chamber in gaseous form and a regulated pumping system to provide a dynamic gas flow through the chamber. An organozinc compound and oxidant in the form of water vapour are carried into the chamber in individual streams of an inert carrier gas. Mixing of the organozinc vapour and oxidant occurs before contact with the heated surface of the substrate in the space between the point of introduction thereof and the heated substrate surface. Reaction between the organozinc compound and oxidant results in decomposition of the organozinc compound to produce zinc oxide, which is deposited upon the substrate as a thin film, with CO₂, CO and volatile hydrocarbons as possible byproducts of the reaction. The zinc oxide film contains hydrogen and may contain an element of Group III of the periodic system where a volatile compound of such an element is also introduced into the deposition chamber.

Suitable organozinc compounds include zinc dialkyls having the formula R₂Zn, wherein R is an alkyl radical, preferably a lower alkyl radical. Dimethylzinc (CH₃)₂Zn and diethylzinc (C₂H₅)₂Zn are particularly preferred.

The composition of the gaseous streams can be varied. The organozinc vapour is produced by vaporising the organozinc compound into the gas stream, for example by bubbling a stream of inert gas through a reservoir of organozinc compound. Other vaporisation methods are equally effective. The mole fraction of the organozinc compound in its carrier gas stream can be up to about 0.5. A mole fraction of about 0.2 is especially preferred.

The water vapour is similarly introduced into the deposition chamber by any suitable method. Bubbling an inert gas through a reservoir of deionised water to produce a mixture of inert carrier gas and water vapour is an effective method for introducing water vapour. The mole fraction of water vapour in its carrier gas stream can be up to about 0.5.

The proportion of water vapour to organozinc compound can be varied depending upon the particular properties of the zinc oxide film desired. In general, an excess of water vapour is desirable. Films deposited using excess organozinc compound have markedly higher resistivities and display poor adhesion to the substrate. A range of about 1 to about 3 moles water vapour per mole of organozinc compound can be used.

The flow rates of the mixture of inert gas and organozinc compound and the mixture of the inert gas and water vapour can be varied depending upon the particular mole ratios and partial pressures of reactants which are intended to be reacted at the surface of the substrate. For example, where bubblers are used to introduce the reactants, flow rates of the mixture of the inert gas and organozinc compound and inert gas and water vapour should be in the range of about 0.897 to about 17.9 standard ml. sec⁻¹. m⁻² (about 5 SCCM to about 100 SCCM per square foot) of deposition surface.

The inert gas used as a carrier for the organozinc vapour and the water vapour can be any inert gas, for example, argon or helium, or any gas which is inert under the conditions prevailing in the deposition chamber, such as nitrogen.

Pressures within the deposition chamber in the range of about 10 Pa to about 300 Pa (about 0.1 torr to about 2 torr) have been found to facilitate the deposition process. Pressures can be varied by control of the reactant gas streams or by means of a regulated pumping system.

Hydrogen-containing zinc oxide deposited according to a process according to the present invention has been found to have a resistivity within the range from about 10⁻⁴ to 10⁻² ohm-cm and a light transmission of greater than 90%. The resistivity can be reduced by adding elements from Group III of the periodic system to the zinc oxide film. For example, aluminium can be introduced by using trimethyl aluminium (CH₃)₃Al. Similarly, boron can be introduced by utilising diborane (B₂H₆). Gallium and indium can also be used as additives. Addition of about 1 to about 4 mole percent of the selected additive or additives based on the organozinc vapour content has been found to be desirable. Addition of about 2 mole percent is preferred. Where boron is to be incorporated into the zinc oxide film, diborane is introduced in a stream of inert gas, such as argon, along with the organozinc compound and water vapour. Boron-containing zinc oxide layers produced in accordance with a process according to the present invention have been found to have resistivities in the range of about 5 x 10⁻⁴ ohm-cm to about 2.5 x 10⁻³ ohm-cm. Aluminium-containing zinc oxide layers have been found to have resitivities in the range of about 1.0 x 10⁻³ ohm-cm to about 2 x 10-³ ohm-cm.

Deposition rates of about 200 Angstroms per minute at 125°C and 600 Angstroms per minute at 150°C are readily attainable. Rates are also controlled in part by gas flow rates and partial pressures of reactants. Zinc oxide films can be deposited to any desired thickness by controlling the time and rate of deposition. Typical films are 1 to 2 micrometres thick. Polycrystalline boron-containing zinc oxide formed is found to have an x-ray diffraction pattern corresponding predominantly to (002) orientation with respect to the plane of the substrate, whereas aluminium-containing zinc oxide has (100) preferred orientation.

By means of a process according to the present invention, it is thus possible to deposit large areas of zinc oxide and to control the resistivity thereof. In this manner, for example, conductive zinc oxide layers for use in solar cells can be readily deposited. Depending upon the particular additive utilised in the process, it is also possible to produce other zinc oxide layers for use in photoconductive devices and having varying physical and electrical properties.

Other additives from Group III of the periodic system than aluminium and boron can be used to provide zinc oxide layers having varying properties. In addition, various other reaction conditions than those specifically mentioned above can be used in a process according to the present invention.

## Claims

1. A process for depositing a zinc oxide film on a substrate, the process comprising introducing an organozinc compound vapour, an oxidant and an inert carrier gas into a chamber containing a substrate to deposit a zinc oxide film on the substrate, the oxidant being water vapour and the substrate being heated to a temperature of up to about 200°C.

2. A process according to claim 1, characterised in that the film is formed by introducing into the chamber an organozinc compound vapour in an amount of up to about 0.5 mole fraction in a stream of the inert carrier gas.

3. A process according to any preceding claim, characterised in that water vapour in an amount of about one to about three moles per mole of organozinc compound is introduced into the chamber.

4. A process according to any preceding claim, characterised in that said temperature is in the range of about 100°C to about 200°C.

5. A process according to claim 4, characterised in that said temperature is up to about 150°C.

6. A process according to any preceding claim, characterised in that the film contains an element of Group III of the periodic system, a volatile compound of said element being also introduced into the chamber.

7. A process according to claim 6, characterised in that said element is boron and the volatile compound is diborane.

8. A process according to claim 6 or 7, characterised in that the volatile compound is introduced into the chamber in an amount of about one to about four mole percent of the organozinc compound.

9. A process according to any preceding claim, characterised in that the organozinc compound has the formula R₂Zn, with R being an alkyl radical.

10. A process according to claim 9, characterised in that the organozinc compound is dimethylzinc.

11. A process according to claim 9, characterised in that the organozinc compound is diethylzinc.

12. A process according to any preceding claim, characterised in that the film has a thickness of up to about 2 micrometres.

13. A process according to any preceding claim, characterised in that the resistivity of the film is within the range from about 10⁻⁴ to 10⁻² ohm-cm.

14. A process according to any preceding claim, characterised in that the resistivity of the film is less than about 2.5 x 10⁻³ ohm-cm.

## Patentansprüche

1. Verfahren zur Abscheidung einer Zinkoxidschicht auf einem Substrat, umfassend die Einleitung des Dampfes einer organischen Zinkverbindung, eines Oxidationsmittels und eines inerten Trägergases in eine ein Substrat enthaltende Kammer zur Abscheidung einer Zinkoxidschicht auf dem Substrat, wobei das Oxidationsmittel Wasserdampf ist und das Substrat auf eine Temperatur bis etwa 200°C erhitzt wird.

2. Verfahren nach Anspruch 1, dadurch gekennzeichnet, daß die Schicht durch Einleiten des Dampfes einer organischen Zinkverbindung in einer Menge bis zu einem Molenbruch von etwa 0,5 in einem Strom des inerten Trägergases in der Kammer gebildet wird.

3. Verfahren nach einem der vorhergehenden Ansprüche, dadurch gekennzeichnet, daß man Wasserdampf in einer Menge von etwa ein bis etwa drei Mol pro Mol organischer Zinkverbindung in die Kammer einleitet.

4. Verfahren nach einem der vorhergehenden Ansprüche, dadurch gekennzeichnet, daß besagte Temperatur im Bereich von etwa 100°C bis etwa 200°C liegt.

5. Verfahren nach Anspruch 4, dadurch gekennzeichnet, daß besagte Temperatur bis etwa 150°C beträgt.

6. Verfahren nach einem der vorhergehenden Ansprüche, dadurch gekennzeichnet, daß die Schicht ein Element aus Gruppe III des Periodensystems enthält, wobei eine flüchtige Verbindung dieses Elements ebenfalls in die Kammer eingeleitet wird.

7. Verfahren nach Anspruch 6, dadurch gekennzeichnet, daß dieses Element Bor und die flüchtige Verbindung Diboran ist.

8. Verfahren nach Anspruch 6 oder 7, dadurch gekennzeichnet, daß man die flüchtige Verbindung in einer Menge von etwa ein bis etwa vier Molprozent der organischen Zinkverbindung in die Kammer einleitet.

9. Verfahren nach einem der vorhergehenden Ansprüche, dadurch gekennzeichnet, daß die organische Zinkverbindung der Formel R₂Zn entspricht, wobei R einen Alkylrest bedeutet.

10. Verfahren nach Anspruch 9, dadurch gekennzeichnet, daß die organische Zinkverbindung Dimethylzink ist.

11. Verfahren nach Anspruch 9, dadurch gekennzeichnet, daß die organische Zinkverbindung Diethylzink ist.

12. Verfahren nach einem der vorhergehenden Ansprüche, dadurch gekennzeichnet, daß der Film eine Dicke bis zu etwa 2 Mikrometer aufweist.

13. Verfahren nach einem der vorhergehenden Ansprüche, dadurch gekennzeichnet, daß der Oberflächenwiderstand der Schicht im Bereich von etwa 10⁻⁴ bis 10⁻² Ohm.cm liegt.

14. Verfahren nach einem der vorhergehenden Ansprüche, dadurch gekennzeichnet, daß der Oberflächenwiderstand der Schicht weniger als etwa 2,5 10⁻³ Ohm.cm beträgt.

## Revendications

1. Procédé de dépôt d'une pellicule d'oxyde de zinc sur un substrat, le procédé consistant à introduire un composé organozincique sous forme de vapeur, un oxydant et un gaz support inerte dans une chambre contenant un substrat pour déposer une pellicule d'oxyde de zinc sur le substrat, l'oxydant étant de la vapeur d'eau et le substrat étant porté à une température allant jusqu'à 200°C environ.

2. Procédé suivant la revendication 1, caractérisé en ce qu'il consiste à former la pellicule en introduisant dans la chambre un composé organozincique sous forme de vapeur, en une quantité représentant une fraction de jusqu'à 0,5 mole environ dans un courant du gaz porteur inerte.

3. Procédé suivant l'une quelconque des revendications précédentes, caractérisé en ce qu'il consiste à introduire dans la chambre de la vapeur d'eau en une quantité de 1 à 3 moles environ par mole du composé organozincique.

4. Procédé suivant l'une quelconque des revendications précédentes, caractérisé en ce que ladite température est comprise entre 100°C et 200°C environ.

5. Procédé suivant la revendication 4, caractérisé en ce que ladite température s'élève jusqu'à 150°C environ.

6. Procédé suivant l'une des revendications précédentes, caractérisé en ce que la pellicule contient un élément du groupe III de la classification périodique des éléments, un composé volatil de cet élément étant également introduit dans la chambre.

7. Procédé suivant la revendication 6, caractérisé en ce que l'élément est le bore et le composé volatil est le diborane.

8. Procédé suivant la revendication 6 ou 7, caractérisé en ce qu'il consiste à introduire le composé volatil dans la chambre en une quantité représentant de un à quatre pour cent en mole du composé organozincique.

9. Procédé suivant l'une quelconque des revendications précédentes, caractérisé en ce que le composé organozincique répond à la formule R₂Zn, R étant un radical alcoyle.

10. Procédé suivant la revendication 9, caractérisé en ce que le composé organozincique est le diméthylzinc.

11. Procédé suivant la revendication 9, caractérisé en ce que le composé organozincique est le diéthylzinc.

12. Procédé suivant l'une quelconque des revendications précédentes, caractérisé en ce que la pellicule a une épaisseur allant jusqu'à 2 microns environ.

13. Procédé suivant l'une quelconque des revendications précédentes, caractérisé en ce que la résistivité de la pellicule est comprise entre 10⁻⁴ et 10⁻² ohm-cm.

14. Procédé suivant l'une quelconque des revendications précédentes, caractérisé en ce que la résistivité de la pellicule est inférieure à 2,5 x 10⁻³ ohm-cm environ.
